# EUROPEAN PATENT APPLICATION

(11) **EP 1 796 100 A2**
(43) Date of publication of application: **13.06.2007**
(21) Application number: 07105490.2
(22) Date of filing: 12.05.2004
(51) Int. Cl.: G11C 11/00

(54) **SDRAM memory device with an embedded NAND flash controller**

(30) Priority: 31.07.2003 US 492217 P; 12.11.2003 US 704613
(62) Divisional of application: 04732398.5
(71) Applicant: M-Systems Flash Disk Pioneers Ltd, 44425 Kfar Saba (IL)
(72) Inventor: Avrahim, Meir, Rishon Lezion 75438 (IL); Inbar, Dan, Yahud 56000 (IL); Paz, Ziv, Shoham 73142 (IL)
(74) Representative: Murgatroyd, Susan Elizabeth

(57) **Abstract**

A memory device (70) comprises a volatile memory (80) operative to provide run-time execution functionality to a host, preferably a and a flash memory (76) operative to store, for the host, code selected from the group consisting of an operating system, a pre-stored application, a downloaded application and user data. The memory device (70) also includes a single interface (84,88) for communicating with the host using only a volatile memory protocol and a controller (78), of the flash memory (76), that is operative to exchange the code with the host (112) independently of the volatile memory (80) and without using the volatile memory (80), in support of the storing of the code, and that also is operative to exchange signals directly between the interface (84,88) and the volatile memory (80) in support of the run-time execution functionality. The invention also relates to a device comprising the CPU, the memory device (70) and a single bus whereby the CPU and the memory device (70) communicate with each other using only signals of the volatile memory protocol, as well as a method of operating the device.

## Description

### FIELD AND BACKGROUND OF THE INVENTION

The present invention relates to memory devices and, more particularly, to a MCP (multi-chip package) memory device with a NAND flash memory on one die and a SDRAM (synchronous dynamic random access memory) together with a controller for the NAND flash memory on another die.

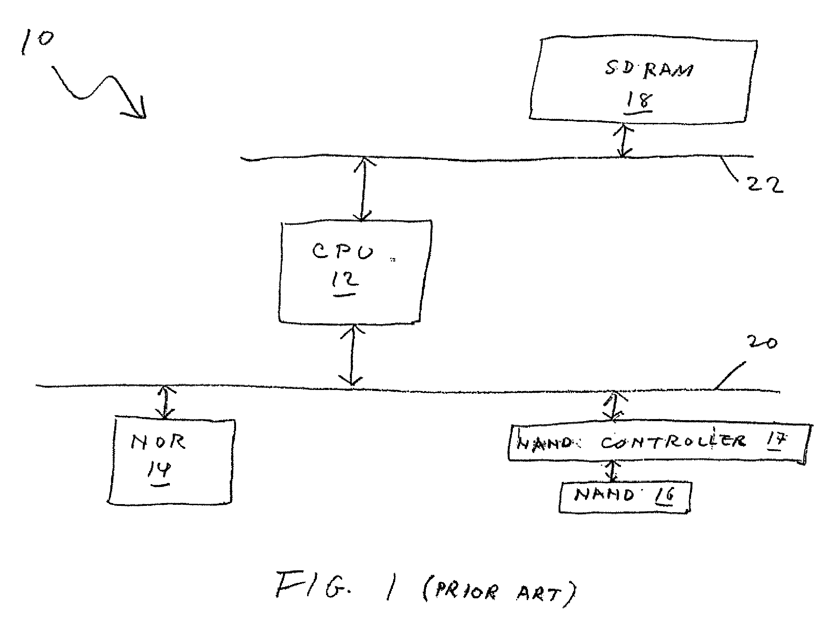

Figure 1 is a partial high level block diagram of a generic prior art embedded device **10.** Device **10** includes a central processing unit (CPU) **12** and three memory devices **14, 16** and **18.** Memory device **14** includes a nonvolatile memory such as a NOR flash memory for storing the operating system and the pre-stored applications of device **10.** Memory device **16** includes a nonvolatile memory, such as a NAND flash memory accessed via a NAND controller **17,** for storing the user's data and downloaded applications. Memory device **18** is a volatile memory such as a SDRAM for run-time execution. CPU **12** communicates with memory devices **14** and **16** via a bus **20** and with memory device **18** via a bus **22.**

The communication protocols of NOR flash memories, NAND flash memories and SDRAM are different. This is why device **10** needs NAND controller 17 and two different buses **20** and **22**. If not for prior art technology described below, an implementation of device **10** that used NAND flash memory in memory device **16** would need three buses.

Typical signals for communicating on bus **20** with a synchronous/asynchronous external memory such as a NOR flash memory or a static random access memory (SRAM) include the following:
**A[0:x]** - Address
**D[0:x] -** Data
**CE# -** Chip Select
**OE#** - Output Enable
**WE#-** Write Enable
**BUSY#** - indicates the status of the memory device
**Reset#** - Reset Signal
**CLK** - system clock

Typical signals for communicating with SDRAM **18** on bus **22** include the following:
**CLK** - System Clock
**CS** - Chip Select
**CKE** - Clock Enable
**BA[0:x] -** Bank Address
**DMQ[0:x] -** Data Input/Output
**A[0:x] -** Row Address, Column Address
**DQ[0:x] -** Data Input/Output
**RAS -** Row Address Strobe
**CAS** - Column Address Strobe
**WE** - Write Enable
A NAND flash memory intrinsically requires a multiplexed interface for Address and Data and control signals which are not included in the signals defined for buses **20** and **22.** If a NAND flash memory device were to have its own bus, the associated signals would include: **I/O [0:x]-** The I/O pins are used to input command, address and data, and to output data during read operations.
**CLE** - controls the activating path for commands sent to the command register.
**ALE** - controls the activating path for address to the internal address registers.
**CS** - Chip Select (or, equivalently, CE - Chip Enable)
**RE -** serial data-out control. When active, drives the data onto the I/O bus.
**WE -** controls writes to the I/O port
**R/B-** indicates device status

In a NOR flash device, reading is random access and fast, similar to RAM (tens of nanoseconds). Writing also is random access but is slow (a few microseconds). Erasing must be done in large chunks called "blocks" and is very slow (a few hundred milliseconds).

In a NAND flash device, reading is serial rather than random access and is somewhat slow (typically 10 to 15 microseconds). Writing must be done in medium-size chunks called "pages" and is slow (a few hundred microseconds). As in the case of a NOR flash device, erasing must be done in blocks, but is much faster (a few milliseconds) than in a NOR flash device.

Recently, NAND flash memory has become an attractive option for data storage in embedded devices such as device **10.** This is because of NAND flash's smaller size, lower cost and faster write speed relative to NOR flash. One of the factors that inhibits the migration from NOR flash to NAND flash in embedded devices is the non-standard interface of NAND flash. To overcome this and other limitations of NAND flash, M-Systems Flash Disk Pioneers, Ltd. of Kfar Saba, Israel introduced technology that enables a NAND flash memory device to use the same memory interface as a NOR flash memory device. This technology is implemented in Figure 1 by NAND flash controller **17.** This technology is described in the DiskOnChip® Millennium Plus Data Sheet, which is available on request from M-Systems Flash Disk Pioneers, Ltd., and which is incorporated by reference for all purposes as if fully set forth herein.

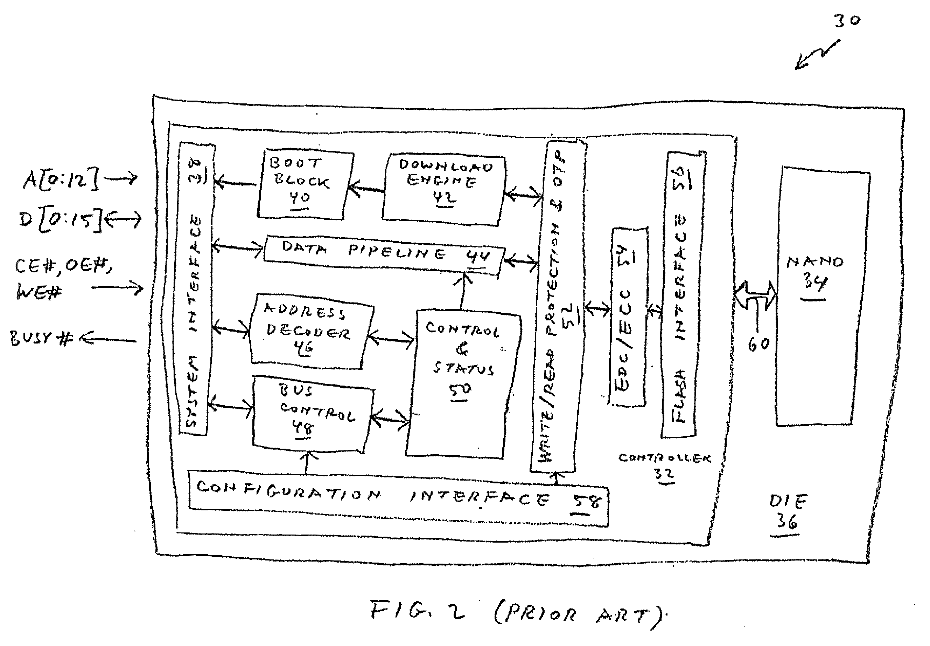

Figure 2 is a simplified block diagram of a prior art NAND flash memory device **30,** specifically M-Systems' DiskOnChip® Millennium Plus. Device **30** includes a NAND flash memory **34** and a controller **32** of NAND flash memory **34,** both fabricated on a common die **36.** The functional blocks of controller 32 include:

A system interface **38** for interfacing with the rest of a host system such as device **10**

A configuration interface **58** for configuring device **30** to operate in 8 bit vs. 16 bit mode, cascaded configuration and hardware write protection

A protection and security-enabling block **52** including Write/Read protection and One-Time Programming (OTP), for advanced data/code security and protection

A programmable boot block **40** with execute-in-place (XIP) capability, enhanced with a download engine **42,** for host system initialization capability

An error detection and error correction code block **54** for on-the-fly error handling

A data pipeline **44** through which data flows from the host system to NAND flash memory **34**

A control and status block **50** that contains registers responsible for transferring the address, data and control information between the software driver and the NAND flash memory **34**

A flash interface **56**

A bus control block **48** for translating the host system bus address, data and control signals into valid NAND flash signals

An address decoder **46** to enable the relevant unit inside controller **32**, according to the address range received from system interface **38.**

More details of these functional blocks are given in the DiskOnChip® Millennium Plus Data Sheet. To the left of device **30** in Figure 2 are shown some of the signals that device **30** exchanges with the host system.

Unlike NOR flash, in which reading is random access, NAND flash does not support execution-in-place, such as is needed to boot the host system. The inclusion of boot block **40** in controller **32** gives device **30** a boot capability that would otherwise be available only in a device such as a NOR flash memory device. Hence, device **30** or a similar device can provide the functionality of both memory device **14** and memory device **16** in device **10.** Such a device **30** could be conveniently packaged inside a common MCP package with SDRAM **18.** Because of the need to use two buses **20** and **22**, however, such an MCP would have to have a correspondingly large number of pins.

There is thus a widely recognized need for, and it would be highly advantageous to have, a memory device including both a NAND flash memory and a SDRAM that can communicate with a host system via a single external bus.

### SUMMARY OF THE INVENTION

According to the present invention there is provided a memory device including: (a) a first die on which is fabricated a first memory; and (b) a second die on which are fabricated: (i) a controller for the first memory, and (ii) at least one additional component.

In its most basic form, a first memory device of the present invention includes two dies. A first memory is fabricated on the first die. A controller for the first memory, and also at least one additional component, are fabricated on the second die.

Preferably, both dies are packaged together in a common package. Most preferably, the first device includes a plurality of pins for operationally connecting the first device to a host system. As understood herein, the term "pin" refers to any kind of lead for establishing an electrical connection between the first device of the present invention and a host system. So, for example the balls of a ball grid array are examples of "pins" as the term "pin" is used herein.

Preferably, the first memory is a nonvolatile memory. More preferably, the first memory is a flash memory. Most preferably, the first memory is a NAND flash memory.

Preferably, one of the additional components is a second memory. Most preferably, the second memory is a volatile memory such as a SDRAM. If the second memory is a SDRAM, then preferably the first device of the present invention includes (for example as part of the controller) a single interface, to a host system, that is appropriate to the SDRAM.

Preferably, the first memory and the additional component(s) communicate with a host system using different respective pluralities of signals. Most preferably, the first device of the present invention includes (for example as part of the controller) a single interface to the host system for communicating with the host system only using the respective signals of the additional component(s), and not the respective signals of the first memory.

Preferably, the controller includes a XIP boot block.

Preferably, the controller also is operative to manage one of the additional component(s). Most preferably, the additional component managed by the controller is a second memory, and the controller provides paging and/or hardware decompression for the second memory.

The scope of the present invention also includes a system that includes the first memory device of the present invention, a CPU and a single bus for communication between the CPU and the first memory device of the present invention. Preferably, the communication via the bus are via signals that are appropriate only to the additional component(s) and not to the first memory.

Also according to the present invention, there is provided a memory device including: (a) a first die on which is fabricated a first memory and a controller for a second memory.

In its most basic form, a second memory device of the present invention includes a first die on which is fabricated a first memory and a controller for a second memory.

Preferably, the second memory is a nonvolatile memory. More preferably, the second memory is a flash memory. Most preferably, the second memory is a NAND flash memory.

Preferably, the first memory is a volatile memory such as a SDRAM. If the first memory is an SDRAM, then preferably the second device of the present invention includes (for example as part of the controller) a single interface, to a host system, that is appropriate to the SDRAM.

Preferably, the second device of the present invention also includes a second die on which is fabricated the second memory. More preferably, both dies are packaged together in a common package. Most preferably, the second device includes a plurality of pins for operationally connecting the second device to a host system.

Preferably, the two memories communicate with a host system using different respective pluralities of signals. Most preferably, the second device of the present invention includes (for example as part of the controller) a single interface to the host system for communicating with the host system only using the respective signals of the first memory, and not the respective signals of the second memory.

Preferably, the controller includes a XIP boot block.

Preferably, the controller also is operative to manage the first memory, for example by providing paging and/or hardware decompression for the first memory.

The scope of the present invention also includes a system that includes the basic second memory device of the present invention, a CPU and a single bus for communicating between the CPU and the second memory device of the present invention. Normally, the system also includes the second memory. Preferably, the communication via the bus are via signals that are appropriate only to the first memory and not to the second memory.

### DEFINITIONS

The scope of the term "SDRAM" as used herein includes any type of synchronous dynamic RAM, including but not limited to DDR SDRAM, QDR SDRAM and derivatives thereof.

### BRIEF DESCRIPTION OF THE DRAWINGS

The invention is herein described, by way of example only, with reference to the accompanying drawings, wherein:
FIG. 1 is a partial high-level block diagram of a generic prior art embedded device;
FIG. 2 is a simplified block diagram of a DiskOnChip® Millennium Plus NAND flash memory device;
FIG. 3 is a high-level block diagram of a memory device of the present invention;
FIG. 4 is a partial high-level block diagram of a generic embedded device of the present invention.

### DESCRIPTION OF THE PREFERRED EMBODIMENTS

The present invention is of a memory device that includes two kinds of memories but communicates with a host device or system using the protocol and signals of only one of the memories. The present invention thereby enables the host device or system to include only one bus for communicating with the two memories.

The principles and operation of a memory device according to the present invention may be better understood with reference to the drawings and the accompanying description.

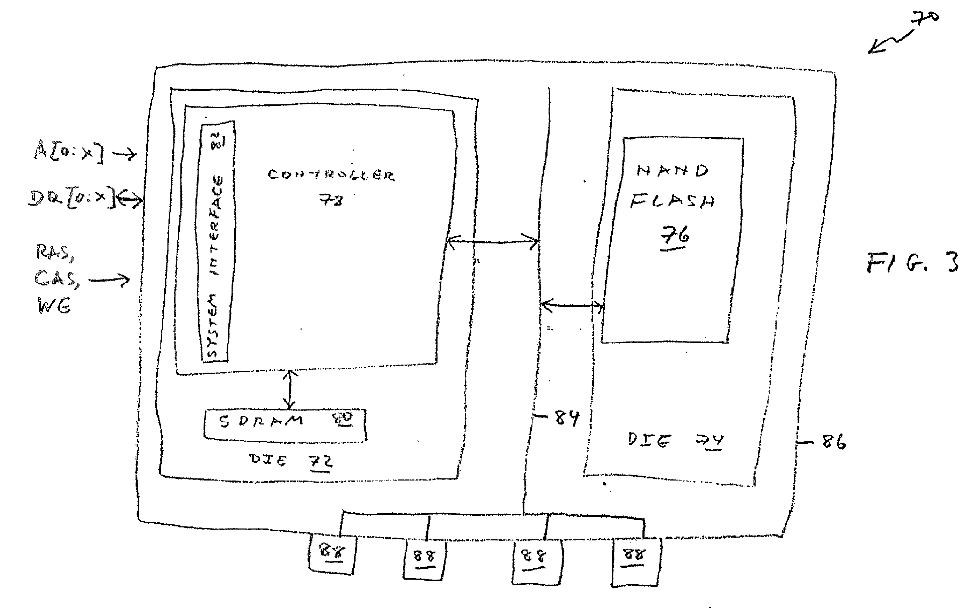

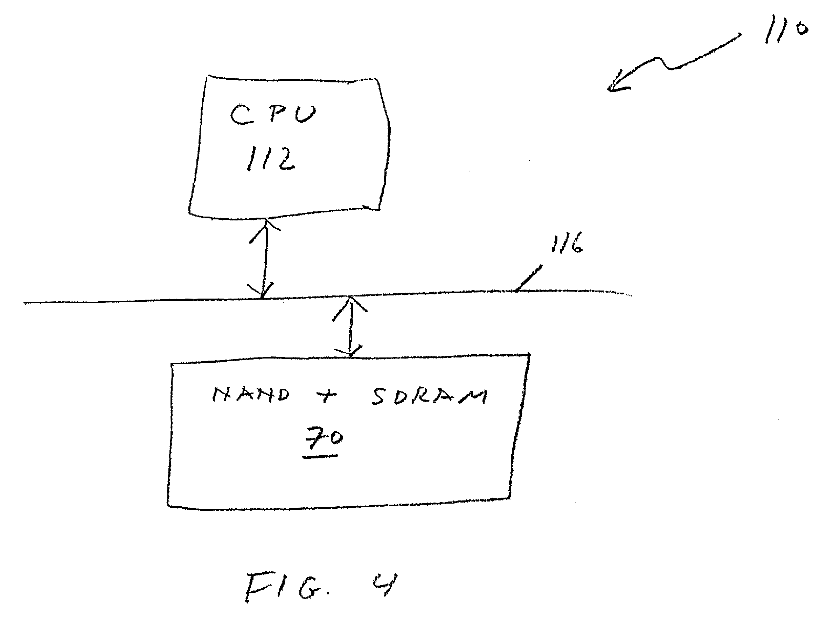

Returning now to the drawings, Figure 3 is a high-level block diagram of a memory device **70** of the present invention. Device **70** includes two dies **72** and **74.** Fabricated on die **74** is a NAND flash memory **76.** Fabricated on die **72** are a controller **78** for NAND flash memory **76** and a SDRAM **80.** Controller **78** is similar to prior art controller **32.** There are three principal differences between controller **78** and controller **32.** The first difference is that in addition to communicating with NAND flash memory **76** (via an internal bus **84),** controller **78** also communicates directly with SDRAM **80,** for example in a direct memory access (DMA) mode. The second difference is that controller **78** can act as a "short" that passes signals directly between the CPU **112** of a host system **110** that includes memory device **70** (see Figure 4 as described below) and SDRAM **80,** with no change to the signals. The third difference is that the signals that controller **78** uses to communicate with an external host system are the signals appropriate to SDRAM **80.** Some of these signals are illustrated to the left of device **70.** In terms of the functional blocks of controller **78,** the only functional block of controller **78** that differs substantially from the corresponding functional block of controller **32** is the system interface block. Unlike system interface block **38** of controller **32,** which supports communication according to a protocol appropriate to a synchronous/asynchronous memory such as a NOR flash memory, system interface block **82** of controller **78** supports communication according to a protocol appropriate to SDRAM **80.** Therefore, the only functional block of controller **78** that is illustrated in Figure 3 is system interface block **82.** It will be clear to those skilled in the art what additional functionality is required in controller **78** to support direct access such as DMA to SDRAM **80.** Therefore, this direct access support functionality is not detailed herein.

Dies **72** and **74** are packaged together in a common package **86,** so that device **70** is a MCP device. Protruding from package **86** is a plurality of pins **88.** Device **70** typically includes significantly fewer pins than the number of pins that device **70** would need to support two separate communication protocols for NAND flash memory **76** and SDRAM **80.** For illustrational simplicity, only four pins **88** are shown in Figure 3.

Figure 3 illustrates a basic memory device 70 of the present invention. A more sophisticated memory device **70** of the present invention includes optional features that take advantage of the presence of NAND flash memory **76** and SDRAM **80** in the same device, for example a decompression engine in controller **78** for compressing data to be stored in NAND flash memory **76** and decompressing that data when that data is loaded from NAND flash memory **76** to SDRAM **80.**

Figure 4 is a partial high level block diagram of a generic embedded device **110** of the present invention. CPU **112** of device **110** is similar to CPU **12** of device **10.** The principal difference between device **10** and device **110** is that in device **110** the functionality of memory devices **14, 16** and **18** is combined into memory device **70** of the present invention. Specifically, NAND flash memory **76** is used for storing the operating system and the pre-stored applications of device **110** and also for storing the user's data and downloaded applications; and SDRAM **80** is used for run-time execution. Consequently, device **110** needs only one bus **116** for communicating with its single memory device **70,** using only signals appropriate for SDRAM **80.**

In addition to the reduced number of buses in device **110** vs. device **10,** the present invention offers the following advantages over the prior art:
1. If (as is preferable) SDRAM **80** is large enough both to hold a shadowed image of the operating system of device **110** and also to provide the memory space required for run time execution, then, because controller **78** includes a boot block and a download engine similar to boot block **40** and download engine **42** of controller **32,** device **70** is a chipset that can boot directly from SDRAM **80.** Because execution from a SDRAM is substantially faster than execution from a NOR flash memory, device **110,** if so configured, operates significantly faster than device **10.**
2. Because device **110** does not need bus **20** to support communication with a NOR flash memory device, CPU chipset vendors are free to eliminate NOR/SRAM signals and the associated pins from their chips. This results in reduced die size, reduced cost of the chipsets and physically smaller package sizes.
3. The transfer of data from NAND flash memory **76** to SDRAM **80** is a fast, direct transfer at low power and without loading an external bus, unlike the transfer of data from NAND flash memory device **16** to SDRAM memory device **18** via external buses **20** and **22.**
4. Optionally, memory management functionality, such as paging and hardware decompression, for managing SDRAM **80** may be included in controller **78.** In device **10,** bus **22** and CPU **12** would have to participate in such functionality.

While the invention has been described with respect to a limited number of embodiments, it will be appreciated that many variations, modifications and other applications of the invention may be made.

## Claims

1. A memory device (70) comprising:
(a) a volatile memory (80) operative to provide run-time execution functionality to a host (112);
(b) a flash memory (76) operative to store, for said host (112), code selected from the group consisting of an operating system, a pre-stored application, a downloaded application and user data;
(c) a single interface (84,88) for communicating with said host (112), said communicating using only a volatile memory protocol; and
(d) a controller (78), of the flash memory (76), that is operative to exchange said code with said host (112) independently of said volatile memory (80) and without using said volatile memory (80), in support of said storing of said code, and that also is operative to exchange signals directly between said interface (84,88) and said volatile memory (80) in support of said run-time execution functionality.

2. The memory device of claim 1, further comprising:
(e) a first die (74) on which said flash memory (76) is fabricated; and
(f) a second die (72) on which said volatile memory (80) and said controller (78) are fabricated.

3. The memory device of claim 1, wherein said flash memory (76) is a NAND flash memory.

4. The memory device of claim 1, wherein said volatile memory (80) is an SDRAM.

5. A device, comprising:
(a) a CPU (112);
(b) a memory device (70) that includes:
(i) a volatile memory (80) for providing run-time execution functionality to said CPU (112),
(ii) a flash memory (76) in which said CPU (112) accesses code selected from the group consisting of an operating system, a pre-stored application, a downloaded application and user data,
(iii) a controller (78), of the flash memory (76), that is operative to exchange said code with said CPU (112) independently of said volatile memory (80) and without using said volatile memory (80), in support of said accessing of said code, and that also is operative to exchange said signals directly between said CPU (112) and said volatile memory (80) in support of said run-time execution functionality, and
(iv) a single interface (84,88) for communicating with said CPU (112) using only signals of a volatile memory protocol; and
(c) a single bus (116) whereby said CPU (112) and said memory device (70) communicate with each other using only said signals of said volatile memory protocol.

6. A method of operating a device that includes a CPU (112), a volatile memory (80), a flash memory (76), the method comprising the steps of the CPU (112):
(a) storing, in the flash memory (76), code selected from the group consisting of an operating system, a pre-stored application, a downloaded application and user data;
(b) using a volatile memory protocol to communicate with the volatile memory (80) for run-time execution; and
(c) using said protocol to communicate with the controller (78) for accessing said code in the flash memory (76), said code being accessed by the controller (78) independently of the volatile memory (80) and without using the volatile memory (80).
